# EUROPEAN PATENT APPLICATION

(11) **EP 4 601 419 A1**
(43) Date of publication of application: **13.08.2025**
(21) Application number: 23894294.0
(22) Date of filing: 16.10.2023
(51) Int. Cl.: H05K 1/02, H05K 3/46, G06F 3/041

(54) **MULTILAYER WIRING SUBSTRATE**

(30) Priority: 24.11.2022 JP 2022187350
(71) Applicant: Panasonic Intellectual Property Management Co., Ltd., Kadoma-shi, Osaka 571-0057 (JP)
(72) Inventor: JEON, Sohui, Kadoma-shi, Osaka 571-0057 (JP); MURAOKA, Keishu, Kadoma-shi, Osaka 571-0057 (JP); SHIBATA, Kenji, Kadoma-shi, Osaka 571-0057 (JP)
(74) Representative: Grünecker Patent- und Rechtsanwälte PartG mbB
(86) International application number: PCT/JP2023/037389
(87) International publication number: WO 2024/111282

(57) **Abstract**

A first conductor pattern (10) and a second conductor pattern (14) are provided with an overlapping pattern (20). The overlapping pattern (20) includes a connection region (21) where multiple first conductive lines (13) and second conductive lines (17) are electrically connected to each other. The second conductive lines (17) located in the connection region (21) are each provided with a via portion (22). The intersection (P) at which one of the first conductive lines (13) and one of the second conductive lines (17) intersect with each other in the connection region (21) is formed such that the via portion (22) is electrically connected to the first conductive line (13). The via portion (22) has a line width equal to or lower than the line width of each of the second conductive lines (17).

## Description

### TECHNICAL FIELD

The present disclosure relates to a multilayer wiring substrate.

### BACKGROUND ART

A traditional multilayer wiring substrate of Patent Document 1 having a via structure is known, for example.

The wiring substrate of Patent Document 1 includes: multiple substrates stacked in an up-down direction; multiple conductive patterns provided between layers of the substrates and on the surface layers of the substrates; and multiple vias disposed between the layers of the substrates. The vias are configured to electrically connect the conductive patterns located between the layers and on the surface layers.

The conductive patterns are each formed of a solid land having a rectangular or circular shape with a predetermined area. The conductive patterns each have a via misalignment tolerance that is smaller than the predetermined area of each of the conductive patterns and located within the predetermined area.

The vias are each made of a conductive paste with which a through holes of each of the substrates is filled, and each have a circular shape in a plan view. The vias each have an area smaller than a predetermined area of each of the conductive patterns. The vias each overlap with the via misalignment tolerance so that the center of each of the vias is located within the via misalignment tolerance in a plan view.

### CITATION LIST

### PATENT DOCUMENT

Patent Document 1: Japanese Unexamined Patent Publication No. 2004-241512

### SUMMARY OF THE INVENTION

### TECHNICAL PROBLEM

In recent years, in the field of multilayer wiring substrates, there has been an increasing demand for products having characteristics such as transparency and light transmission. On the premise of such a background, for example, it is assumed that a substrate having transparency and light transmission is applied to the wiring substrate of Patent Document 1.

However, when a substrate having transparency and light transmission is applied to the wiring substrate of Patent Document 1, the solid conductive patterns each having the predetermined area and the vias overlapping with the via misalignment tolerance are conspicuous in a plan view. As a result, the transparency and the light transmission are impaired. As described above, in the configuration in which the substrate having transparency and light transmission is applied to the wiring substrate of Patent Document 1, the transparency and light transmission cannot be sufficiently obtained due to the conductive patterns and the vias.

The present disclosure was made in view of the problems, and it is an objective of the present disclosure to ensure transparency and light transmission of the substrate in a multilayer wiring substrate having a via structure.

### SOLUTION TO THE PROBLEM

In order to achieve the above objective, an embodiment of the present disclosure is directed to a multilayer wiring substrate including: a substrate having transparency and light transmission; and a first conductor pattern and a second conductor pattern arranged at different positions from each other in a thickness direction of the substrate. The first conductor pattern is made of multiple first conductive lines that have been thinned. The second conductor pattern is made of multiple second conductive lines that have been thinned. The first conductor pattern and the second conductor pattern is provided with an overlapping pattern where the first conductor pattern and the second conductor pattern partially overlap with each other in the thickness direction of the substrate. In the overlapping pattern, the multiple first conductive lines and the multiple second conductive lines intersect with each other in a plan view. The overlapping pattern includes at least one connection region where the multiple first conductive lines and the multiple second conductive lines are electrically connected to each other. The second conductive lines located in the connection region each have at least one via portion. At an intersection at which one of the multiple first conductive lines and one of the multiple second conductive lines intersect with each other in the connection region, the at least one via portion is formed to be electrically connected to the one of the multiple first conductive lines. The at least one via portion has a line width equal to or lower than a line width of the one of the multiple second conductive lines.

### ADVANTAGES OF THE INVENTION

According to the present disclosure, the multilayer wiring substrate having a via structure can ensure the transparency and the light transmission of the substrate.

### BRIEF DESCRIPTION OF THE DRAWINGS

[FIG. 1] FIG. 1 is a perspective view of the entirety of a multilayer wiring substrate according to an embodiment of the present disclosure.
[FIG. 2] FIG. 2 is a plan view of the entirety of the multilayer wiring substrate according to the embodiment of the present disclosure.
[FIG. 3] FIG. 3 is a partially enlarged plan view of a portion III of FIG. 2.
[FIG. 4] FIG. 4 is a partially enlarged plan view of a portion IV of FIG. 3.
[FIG. 5] FIG. 5 is a partially enlarged plan view of a connection region and its periphery shown in FIG. 4.
[FIG. 6] FIG. 6 is a cross-sectional view taken along line VI-VI of FIG. 5.
[FIG. 7] FIG. 7 is a partially enlarged cross-sectional view of a portion VII of FIG. 6.
[FIG. 8] FIG. 8 is a cross-sectional view taken along line VIII-VIII of FIG. 5.
[FIG. 9] FIG. 9 is a partially enlarged cross-sectional view of a portion IX of FIG. 8.
[FIG. 10] FIG. 10 is a schematic view of a method for producing a multilayer wiring substrate by imprinting technique.
[FIG. 11] FIG. 11 is a schematic plan view of a configuration of a first conductor pattern, a second conductor pattern, and an overlapping pattern in a first variation of the embodiment.
[FIG. 12] FIG. 12 is a schematic plan view of a configuration of a first conductor pattern, a second conductor pattern, and an overlapping pattern in a second variation of the embodiment.
[FIG. 13] FIG. 13 is a schematic plan view of a configuration of a first conductor pattern, a second conductor pattern, and an overlapping pattern in a third variation of the embodiment.
[FIG. 14] FIG. 14 is a view corresponding to FIG. 13, illustrating a state where the first bridge portions located in the connection region partially overlap with the second conductive lines, and second bridge portions located in the connection region partially overlap with the second conductive lines, in a third variation of the embodiment.
[FIG. 15] FIG. 15 is a view corresponding to FIG. 6, illustrating a cross-sectional configuration of a connection region and its periphery in a fourth variation of the embodiment.
[FIG. 16] FIG. 16 is a view corresponding to FIG. 6, illustrating a cross-sectional configuration of a connection region and its periphery in a fifth variation of the embodiment.
[FIG. 17] FIG. 17 is a schematic view of a method for producing a multilayer wiring substrate by etching technique.
[FIG. 18] FIG. 18 is a view corresponding to FIG. 6, illustrating a cross-sectional configuration of a connection region and its periphery in a sixth variation of the embodiment.

### DESCRIPTION OF EMBODIMENTS

Embodiments of the present disclosure are described below with reference to the drawings. The following description of the embodiments is merely exemplary in nature and is not intended to limit the present disclosure, its application, or its use.

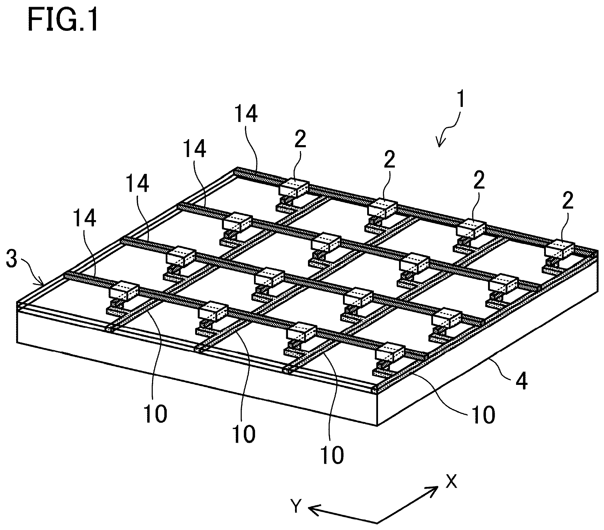

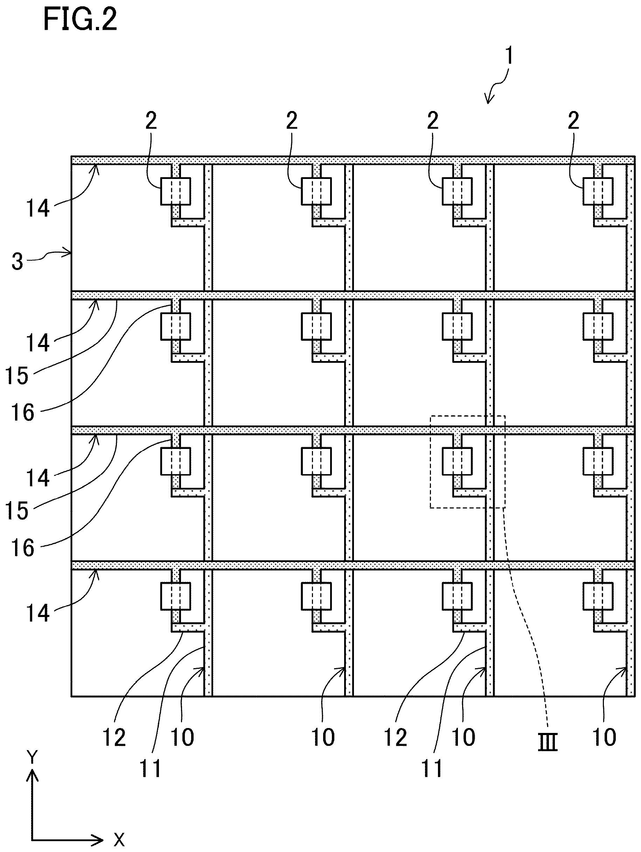

FIGS. 1 and 2 show general configurations of a multilayer wiring substrate 1 according to an embodiment of the present disclosure. This embodiment shows a multilayer wiring substrate 1 formed by imprinting technique. The multilayer wiring substrate 1 include multiple mounted elements 2. Examples of the mounted elements 2 include an LED elements and diodes. The mounted elements 2 are arranged on a substrate 3 to be described later (the upper surface side of a first layer 5 to be described later).

In this embodiment, for convenience of explanation, the direction from the left to the right of the sheet of FIG. 2 is defined as an "X direction," and the direction from the bottom to the top of the sheet of FIG. 2 is defined as a "Y direction."

### (Substrate)

As illustrated in FIGS. 1 and 2, the multilayer wiring substrate 1 includes a substrate 3. The substrate 3 has transparency and light transmission. In this embodiment, in the thickness direction of the substrate 3, the side on which a film base material 4 to be described later is located is defined as the "lower side" of the substrate 3, and the side on which a second layer 6 to be described later is located is defined as the "upper side" of the substrate 3.

The substrate 3 includes the film base material 4. The film base material 4 is made of a resin material having at least flexibility and light transmission. It is preferable that the film base material 4 has a light transmittance of 80% or higher. The film base material 4 has a thickness of, for example, 25 µm to 200 µm. The film base material 4 may have transparency.

Examples of the resin material include resin materials, such as polyethylene terephthalate (PET), polycarbonate, a cycloolefin polymer (COP), and a cycloolefin copolymer (COC).

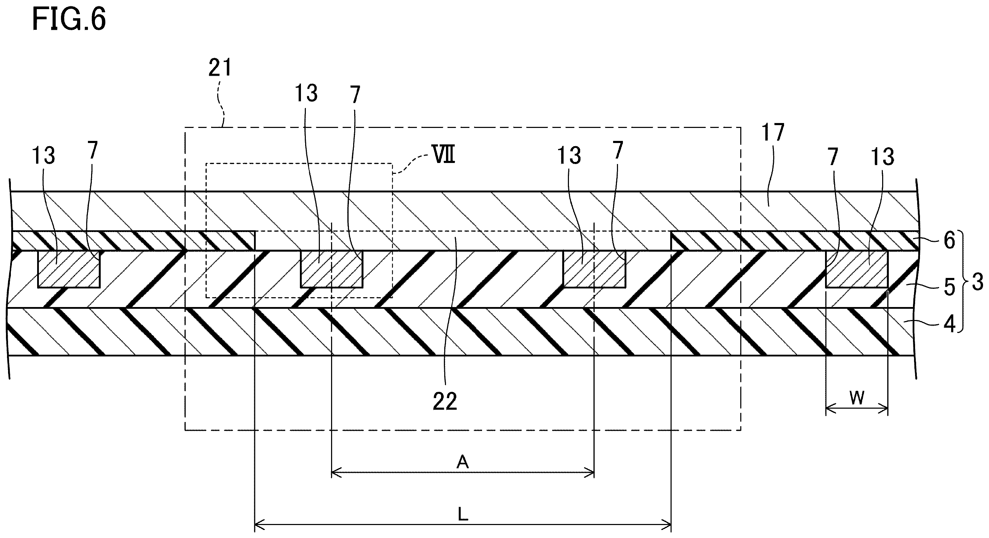

As illustrated in FIG. 6, the substrate 3 includes a first layer 5 and a second layer 6. The first layer 5 and the second layer 6 are each made of a resin material having insulation properties and light transmission. Examples of the resin material include a thermosetting resin material and an ultraviolet curable resin material. The first layer 5 and the second layer 6 each have a thickness of 1 µm to 6 µm, for example.

The first layer 5 is a layer for arranging first conductor patterns 10 to be described later. The first layer 5 is stacked on the film base material 4. The upper surface of the first layer 5 is formed to be flat or slightly recessed in a central portion with a conductive metal forming first conductive lines 13 embedded in first recesses 7.

The second layer 6 is a layer for arranging second conductor patterns14 to be described later. The second layer 6 is stacked on the first layer 5. The upper surface of the second layer 6 is formed to be flat or slightly recessed in a central portion with a conductive metal forming second conductive lines 17 embedded in second recesses 8.

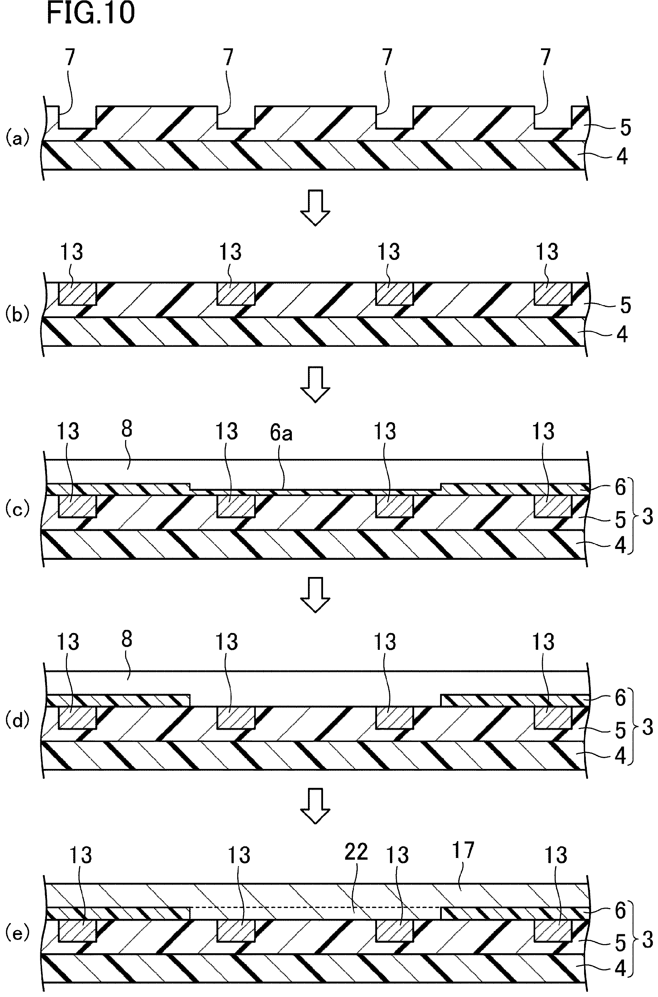

As illustrated in FIGS. 6 and 10, the first layer 5 is provided with multiple bottomed first recesses 7 recessed downward from the upper surface of the first layer 5. The first recesses 7 linearly extend to form a predetermined pattern to be described later on the upper surface of the first layer 5.

The groove depth of each of the first recesses 7 is, for example, from 0.5 µm to 5 µm inclusive. The first recess 7 is formed to have a groove width of 15 µm or less.

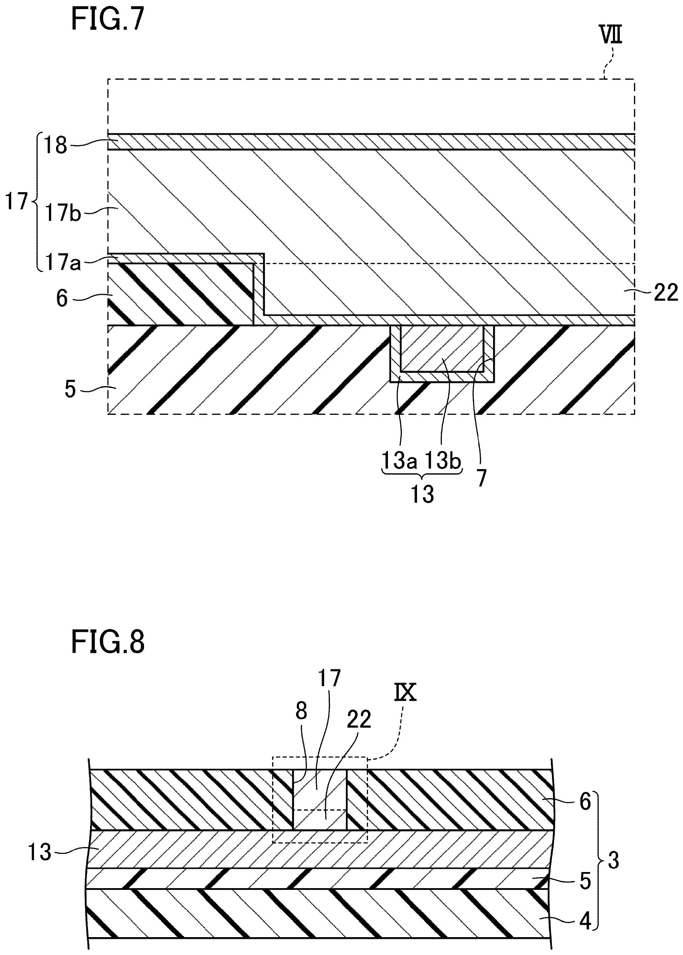

As illustrated in FIGS. 8 to 10, the second layer 6 is provided with multiple second recesses 8 recessed downward from the upper surface of the second layer 6. The second recesses 8 linearly extend to form a predetermined pattern to be described later on the upper surface of the second layer 6. The second recesses 8 are formed such that only a portion in which a via portion 22 to be described later is formed penetrates in the thickness direction of the substrate 3.

The groove depth of each of the second recesses 8 is, for example, from 0.5 µm to 5 µm inclusive. The second recess 8 is formed to have a groove width of 15 µm or less.

### (First Conductor Pattern)

As illustrated in FIGS. 1 to 3, the multilayer wiring substrate 1 includes multiple first conductor patterns 10. The first conductor patterns 10 are arranged at intervals (equal intervals in the illustrated example) in the X direction in a plan view. The first conductive lines 13 to be described later forming each of the first conductor patterns 10 are arranged in the first layer 5 (see FIG. 6). In FIGS. 1 to 3, for convenience of illustration, the first conductor patterns 10 are illustrated by dot hatching.

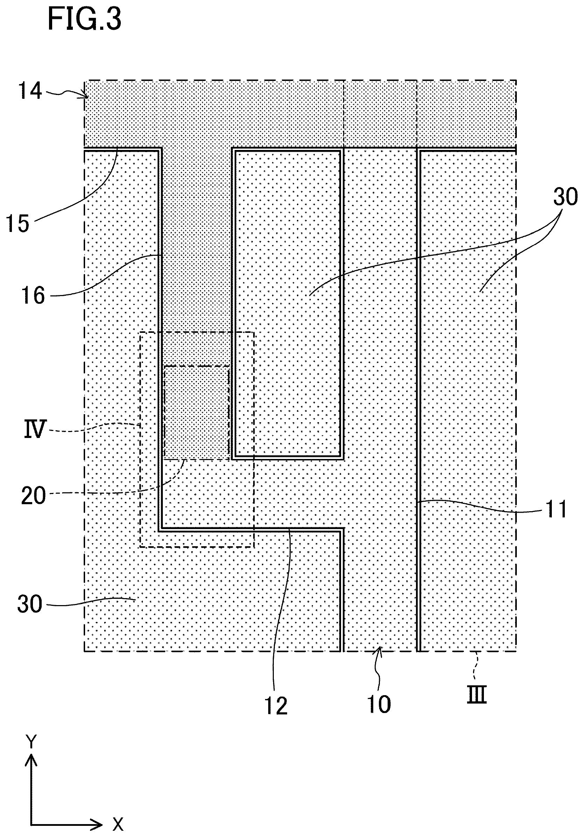

The first conductor patterns 10 each include a first body portion 11 and multiple (four in the illustrated example) first branch portions 12. The first body portion 11 and the first branch portions 12 are each formed in a substantially band shape in a plan view. The first body portion 11 extends in a substantially band shape along the Y direction in a plan view. The first branch portions 12 branch from the respective partway portions of the first body portion 11. Specifically, the first branch portions 12 are formed to extend from the respective partway portions of the first body portion 11 toward the direction opposite to the X direction (a direction toward the left of the sheet in FIGS. 2 and 3).

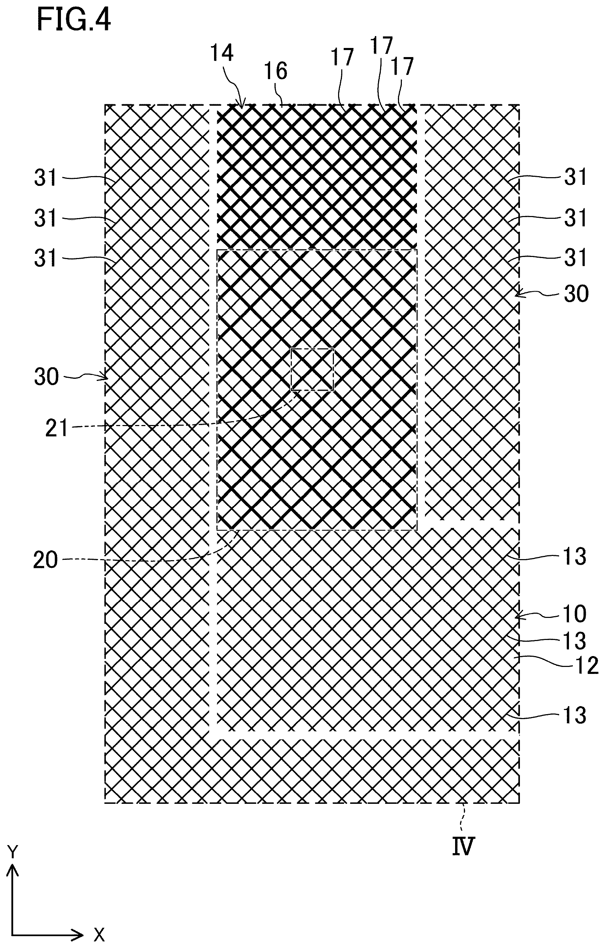

As illustrated in FIG. 4, the first conductor pattern 10 is made of multiple first conductive lines 13. The first conductive lines 13 have each been thinned. Specifically, the first conductive lines 13 are each formed to have a line width of 15 µm or less.

The first conductive lines 13 are arranged in a predetermined pattern on the surface of the first layer 5. FIG. 4 shows a mesh pattern in which the first conductive lines 13 are arranged in a mesh shape, as an example of the predetermined pattern.

The mesh pattern (the first conductor pattern 10) made of multiple first conductive lines 13 is formed such that the first conductive lines 13 intersect with each other and arranged at predetermined intervals (equal intervals in the illustrated example). The first conductive lines 13 forming the mesh pattern extend obliquely with respect to both the X direction and the Y direction.

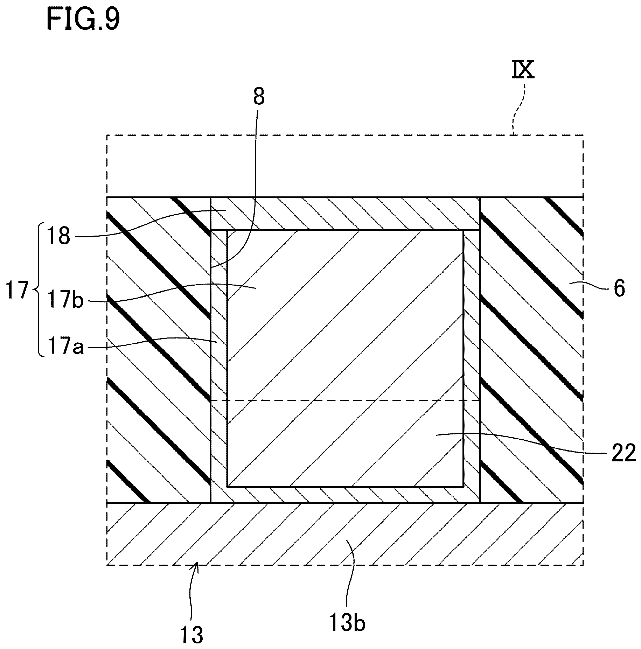

As illustrated in FIGS. 7 and 9, the first conductive lines 13 each include an adhesive layer 13a and a conductive layer 13b. In FIGS. 6, 8, and 10, for convenience of illustration, the illustration of the adhesive layer 13a and the conductive layer 13b is omitted.

The adhesive layer 13a is an element for ensuring adhesion of the conductive layer 13b to the first recess 7 (see FIGS. 6 and 7). The adhesive layer 13a has low reflectivity. In other words, the adhesive layer 13a has a function of making the conductive layer 13b less visible when the multilayer wiring substrate 1 is viewed from the side on which the first layer 5 is located (the lower side of the sheet in FIG. 7).

The adhesive layer 13a is a metal layer made of, for example, a metal nitride or a metal oxide containing at least one metal selected from the group consisting of Ti, Al, V, W, Ta, Si, Cr, Ag, Mo, Cu, Zn, or a metal oxynitride containing both the metal nitride and the metal oxide. The adhesive layer 13a may be a single layer or a laminate of multiple layers with different compositions.

The adhesive layer 13a is formed on the side surfaces and the bottom surface of the first recess 7. Specifically, the adhesive layer 13a is stacked as a thin film on the side surfaces and the bottom surface of the first recess 7 by vapor deposition or sputtering, for example.

The conductive layer 13b is an element for ensuring conductivity of the first conductive line 13. The conductive layer 13b is embedded in the first recess 7 in the state of being stacked on the adhesive layer 13a. The conductive layer 13b is made of a conductive metal. Suitable examples of the conductive metal include copper, silver, gold, and an alloy containing at least one of these metals. The conductive layer 13b is formed by vapor deposition, sputtering, electroless plating, or electroplating, for example. The upper surface of the conductive layer 13b is formed to be preferably flush with the upper surface of the first layer 5 (see FIG. 7).

### (Second Conductor Pattern)

As illustrated in FIGS. 1 to 3, the multilayer wiring substrate 1 includes multiple second conductor patterns 14. The second conductor patterns 14 are arranged at intervals (equal intervals in the illustrated example) in the Y direction in a plan view. In FIGS. 1 to 3, for convenience of illustration, the second conductor patterns 14 are illustrated by dot hatching.

The second conductive lines 17 to be described later forming each of the second conductor patterns 14 are arranged in the second layer 6 (see FIG. 6). In other words, the second conductor patterns 14 are arranged at different positions from the first conductor patterns 10 in the thickness direction of the substrate 3.

The second conductor patterns 14 each include a second body portion 15 and multiple (four in the illustrated example) second branch portions 16. The second body portion 15 and the second branch portions 16 are each formed in a substantially band shape in a plan view. The second body portion 15 extends in a substantially band shape along the X direction in a plan view. The second branch portions 16 branch from the respective partway portions of the second body portion 15. Specifically, the second branch portions 16 extend from the respective partway portions of the second body portion 15 toward the direction opposite to the Y direction (lower side in the sheet of FIG. 2).

As illustrated in FIG. 4, the second conductor pattern 14 is made of multiple second conductive lines 17. The second conductive lines 17 have each been thinned. Specifically, the second conductive lines 17 are each formed to have a line width of 15 µm or less. In FIG. 4, in order to distinguish the first conductive line 13 from the second conductive line 17, the second conductive line 17 is illustrated using a thicker line than the first conductive line 13.

As illustrated in FIGS. 4 and 6, the second conductive lines 17 are arranged in a predetermined pattern on the surface of the second layer 6. FIG. 4 shows a mesh pattern in which the second conductive lines 17 are arranged in a mesh shape, as an example of the predetermined pattern.

As illustrated in FIG. 4, the mesh pattern (the second conductor pattern 14) made of multiple second conductive lines 17 is formed such that the second conductive lines 17 intersect with each other and arranged at predetermined intervals (equal intervals in the illustrated example). The second conductive lines 17 forming the mesh pattern extend obliquely with respect to both the X direction and the Y direction. In this embodiment, the mesh pattern made of the second conductive lines 17 has the same aperture ratio as that of the mesh pattern (the first conductor pattern 10) made of the first conductive lines 13.

The proportion of the first conductive lines 13 in the first conductor pattern 10 or the proportion of the second conductive lines 17 in the second conductor pattern 14 is referred to as "shadow rate." The ratio obtained by subtracting the shadow rate from the entire area (100%) of the first conductor pattern 10 corresponds to the aperture ratio of the first conductor pattern 10. Similarly, the ratio obtained by subtracting the shadow rate from the entire area (100%) of the second conductor pattern 14 corresponds to the aperture ratio of the second conductor pattern 14.

As illustrated in FIGS. 7 and 9, the second conductive lines 17 each include an adhesive layer 17a, a conductive layer 17b, and a blackening layer 18. In FIGS. 6, 8, and 10, for convenience of illustration, the illustration of the adhesive layer 17a, the conductive layer 17b, and the blackening layer 18 is omitted.

The adhesive layer 17a is an element for ensuring adhesion of the conductive layer 17b to the second recess 8 (see FIGS. 8 and 9). The adhesive layer 17a has low reflectivity. In other words, the adhesive layer 17a has a function of making the conductive layer 17b less visible when the multilayer wiring substrate 1 is viewed from the side on which the first layer 5 is located (the lower side of the sheet in FIG. 7).

The adhesive layer 17a is a metal layer made of, for example, a metal nitride or a metal oxide containing at least one metal selected from the group consisting of Ti, Al, V, W, Ta, Si, Cr, Ag, Mo, Cu, and Zn, or a metal oxynitride containing both the metal nitride and the metal oxide. The adhesive layer 17a may be a single layer or a laminate of multiple layers with different compositions.

The adhesive layer 17a is formed on the side surfaces and the bottom surface of the second recess 8. Specifically, the adhesive layer 17a is stacked as a thin film on the side surfaces and the bottom surface of the second recess 8 by vapor deposition or sputtering, for example. The adhesive layer 17a is formed also in a portion of the second recess 8 where a via portion 22 to be described later is formed (specifically, portions corresponding to the lower surface and the side surfaces of the via portion 22).

The conductive layer 17b is an element for ensuring conductivity of the second conductive line 17. The conductive layer 17b is embedded in the second recess 8 in the state of being stacked on the adhesive layer 17a. The conductive layer 17b is made of a conductive metal. Suitable examples of the conductive metal include copper, silver, gold, and an alloy containing at least one of these metals. The conductive layer 17b is formed by vapor deposition, sputtering, electroless plating, or electroplating, for example.

As illustrated in FIGS. 7 and 9, the blackening layer 18 is stacked on the upper surface of the conductive layer 17b. The blackening layer 18 has low reflectivity. In other words, the blackening layer 18 has a function of making the conductive layer 17b less visible when the multilayer wiring substrate 1 is viewed from the side on which the second layer 6 is located. The blackening layer 18 has a thickness of 7 nm to 10 nm, for example. The blackening layer 18 is formed by vapor deposition, sputtering, electroplating, or electroless plating.

When the blackening layer 18 is formed by, for example, electroless plating, the composition of the electroless plating solution used in electroless plating is not particularly limited. For example, when the metal atom in the conductive layer 17b is copper, the atom to be replaced by copper (i.e., the constituent atom of the blackening layer 18) is one element selected from the group consisting of Pd, Hg, Ag, Ir, Pt, and Au. In the following description, the case where palladium (Pd) is used as the constituent atom of the blackening layer 18 is shown as an example.

In this embodiment, the blackening layer 18 is formed by replacing (blackening), by palladium, crystal grains at the interface (so-called "grain boundary") between crystal grains on the surface layer side in the conductive metal forming the conductive layer 17b. Specifically, in the blackening, grain-boundary corrosion progresses along the grain boundary, and crystal grains of copper or the like forming the surface layer of the conductive metal is replaced by palladium. It is preferable that the upper surface of the blackening layer 18 (corresponding to the upper surface of each of the second conductive lines 17) is formed to be flush with the upper surface of the second layer 6 (see FIG. 9).

### (Overlapping Pattern)

As illustrated in FIGS. 3 and 4, the first conductor pattern 10 and the second conductor pattern 14 are provided with an overlapping pattern 20. The overlapping pattern 20 is formed such that the first conductor pattern 10 and the second conductor pattern 14 partially overlap with each other in the thickness direction of the substrate 3. The overlapping pattern 20 of this embodiment is formed such that the first branch portion 12 and the second branch portion 16 partially overlap with each other in this thickness direction of the substrate 3.

The interval between the first conductive lines 13, 13 in the overlapping pattern 20 is larger than the interval between the first conductive lines 13, 13 in the first conductor pattern 10 other than the overlapping pattern 20. In this embodiment, the interval between the first conductive lines 13, 13 forming the overlapping pattern 20 is about twice the interval between the first conductive lines 13, 13 in the first conductor pattern 10 other than the overlapping pattern 20. Similarly, the interval between the second conductive lines 17, 17 forming the overlapping pattern 20 is about twice the interval between the second conductive lines 17, 17 in the second conductor pattern 14 other than the overlapping pattern 20.

In the overlapping pattern 20, the first conductive lines 13 intersect with the second conductive lines 17 in a plan view. Then, the overlapping pattern 20 is formed such that the first conductive lines 13 and the second conductive lines 17 are arranged at predetermined intervals (equal intervals in the illustrated example) in a plan view.

The aperture ratio of the overlapping pattern 20 is preferably made such that the difference between the aperture ratio of the overlapping pattern 20 and the aperture ratio of the first conductor pattern 10 (or the aperture ratio of the second conductor pattern 14) in the region other than a connection region 21 to be described later is 30% or less. The difference between the aperture ratios is more preferably 10% or less. The overlapping pattern 20 of this embodiment has the same aperture ratio as the aperture ratio of the first conductor pattern 10 (or the aperture ratio of the second conductor pattern 14) other than the overlapping pattern 20.

### (Connection Region)

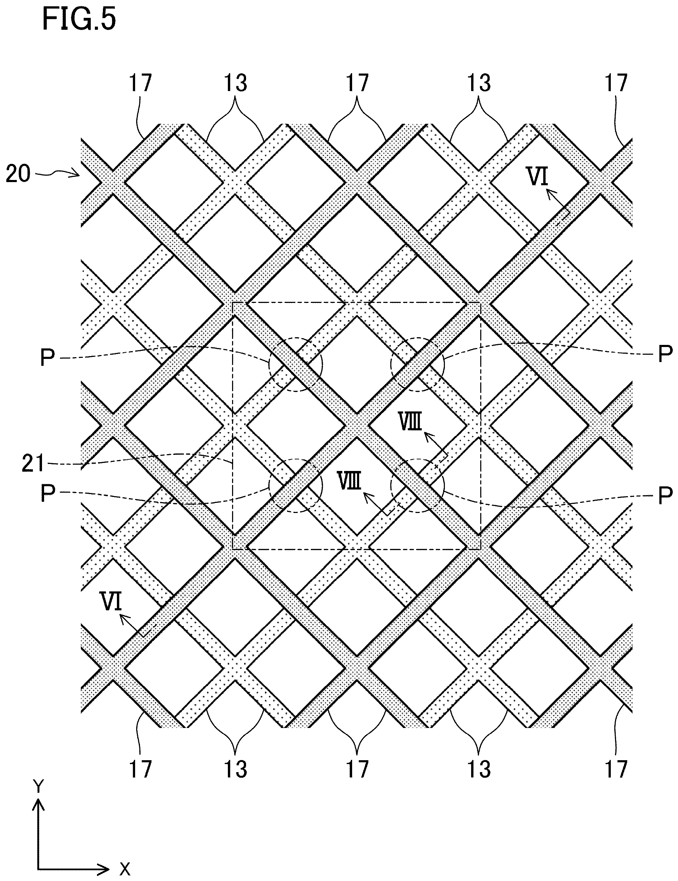

As illustrated in FIGS. 4 and 5, the overlapping pattern 20 includes a connection region 21. In the connection region 21, the first conductive lines 13 and the second conductive lines 17 are electrically connected. The overlapping pattern 20 of this embodiment includes one connection region 21.

In this embodiment, the connection region 21 is smaller than the region of the overlapping pattern 20. In the connection region 21, multiple (four in the illustrated example) first conductive lines 13 and multiple (four in the illustrated example) second conductive lines 17 are located. In the connection region 21, multiple first conductive lines 13 intersect with one second conductive line 17 (see intersections P shown in FIG. 5). In the connection region 21 shown in FIG. 5, four intersections P are located.

### (Via Portion)

As illustrated in FIGS. 6 to 9, each of the second conductive lines 17 located in the connection region 21 has one via portion 22. The via portion 22 is disposed in the connection region 21. The via portion 22 is made of the same material as the conductive metal of the conductive layer 17b forming each of the second conductive lines 17.

The via portion 22 is integral with the second conductive line 17 (the conductive layer 17b) located in the connection region 21. The via portion 22 of this embodiment protrudes from the lower portion of the second conductive line 17 (conductive layer 17b) toward a position corresponding to the upper surface of the first layer 5.

The via portion 22 is formed to have a line width which is equal to or lower than the line width of the second conductive line 17. The via portion 22 of this embodiment has the same line width as the line width of the second conductive line 17 (see FIG. 8).

In this embodiment, the via portion 22 is formed such that the angle formed between the side surface of the via portion 22 and the lower surface of the second conductive line 17 is substantially a right angle in a cross-sectional view (see FIG. 6). The angle formed between the side surface of the via portion 22 and the lower surface of the second conductive line 17 is not limited to a right angle, and may be an obtuse angle slightly larger than the right angle (specifically, an angle corresponding to the draft angle generated when the second recess 8 is formed by imprinting technique). The embodiment in which the angle formed between the side surface of the via portion 22 and the lower surface of the second conductive line 17 is an obtuse angle which is larger than the draft angle will be described in a fourth variation later.

The intersection at which the first conductive line 13 and the second conductive line 17 intersect with each other in the connection region 21 (the intersection P shown in FIG. 5) is formed such that the via portion 22 is electrically connected to the first conductive line 13. In this embodiment, at the intersection P, the lower surface of the via portion 22 is in contact with the upper surface of the first conductive line 13 located in the connection region 21.

In this embodiment, the via portion 22 is electrically connected to two first conductive lines 13, 13 at two intersections P, P at which the two first conductive lines 13, 13 intersect with one second conductive line 17. The via portion 22 is formed such that the length (dimension L shown in FIG. 6) along the extending direction of the second conductive line 17 is equal to or greater than the sum of the pitch interval (dimension A shown in FIG. 6) of the first conductive lines 13, 13 adjacent to each other in the extending direction and the line width (dimension W shown in FIG. 6) of one first conductive line 13. In this embodiment, one via portion 22 overlaps with two first conductive lines 13,13 adjacent to each other in the extending direction of the second conductive line 17 in the thickness direction of the substrate 3 (see FIG. 6). The second layer 6 is interposed between the first conductive line 13 that does not overlap with the via portion 22 and each of the second conductive lines 17 (see FIG. 6).

### (Dummy Pattern)

As illustrated in FIGS. 3 and 4, the multilayer wiring substrate 1 includes multiple dummy patterns 30. In FIG. 3, each of the dummy patterns 30 is simply illustrated by dot hatching. In FIGS. 1 and 2, illustration of the dummy patterns 30 is omitted.

In this embodiment, the dummy patterns 30 are arranged in the first layer 5. Specifically, the dummy patterns 30 are arranged in regions of the first layer 5 where the first conductor patterns 10 and the second conductor patterns 14 are not located (see FIGS. 1 and 2) in a plan view.

As illustrated in FIG. 4, the dummy patterns 30 are each made of multiple dummy conductive lines 31. The dummy conductive lines 31 have each been thinned. Specifically, the dummy conductive lines 31 are each formed to have a line width of 15 µm or less.

The dummy conductive lines 31 each include a conductive metal embedded in a recess (not shown) of the first layer 5. Suitable examples of the conductive metal include copper, silver, gold, and an alloy containing at least one of these metals. The recess is formed on the upper surface side of the region of the first layer 5 where the first conductor patterns 10 are not located. The recess has the same configuration as the first recess 7. Although not shown, the dummy conductive lines 31 are each formed such that its upper surface is flush with the upper surface of the first layer 5.

The dummy conductive lines 31 are formed in a mesh pattern in which the dummy conductive lines 31 are arranged in a mesh shape. The mesh pattern made of the dummy conductive lines 31 has the same configuration as the mesh pattern made of the first conductive lines 13. The dummy pattern 30 has the same aperture ratio as the aperture ratio of the first conductor pattern 10.

The dummy conductive lines 31 are arranged at intervals from the first conductive lines 13 forming the first conductor pattern 10 adjacent to each dummy pattern 30 in a plan view. In other words, the dummy patterns 30 are in an electrically non-conductive state with the first conductor patterns 10. Although not shown, the dummy patterns 30 are insulated from the second conductor patterns 14 via the second layer 6.

### (Method for Producing Multilayer Wiring Substrate)

A method for producing a multilayer wiring substrate 1 will be described with reference to FIG. 10. Specifically, in this embodiment, the method for producing a multilayer wiring substrate 1 by imprinting technique will be described.

First, a first layer 5 is formed on the upper surface of a film base material 4. Specifically, a resin material having insulation properties and light transmission (the thermosetting resin material or the ultraviolet curable resin material) is applied to the upper surface of the film base material 4. Then, first recesses 7 are formed on the upper surface side of the first layer 5 by imprinting technique. Thus, the first layer 5 having multiple first recesses 7 is stacked on the upper surface of the film base material 4 (see the cross-sectional view shown in (a) of FIG. 10). The angle formed between the bottom surface and the side surface of the first recess 7 is a right angle or an obtuse angle slightly larger than the right angle (i.e., the angle corresponding to the draft angle generated when the first recess 7 is formed by imprinting technique).

Next, multiple first conductive lines 13 forming a first conductor pattern 10 are formed. Specifically, an adhesive layer 13a is formed in each of the first recesses 7 by vapor deposition or sputtering. Thereafter, a conductive layer 13b made of a conductive metal such as copper is staked on the adhesive layer 13a by electroplating, for example. Thus, the first conductive lines 13 are formed in the first layer 5 (see the cross-sectional view shown in (b) of FIG. 10).

Next, a second layer 6 is formed on the upper surface of the first layer 5. Specifically, a resin material having insulation properties and light transmission (the thermosetting resin material or the ultraviolet curable resin material) is applied to the upper surface of the first layer 5. Then, second recesses 8 are formed on the upper surface side of the second layer 6 by imprinting technique. Thus, the second layer 6 having the second recesses 8 is stacked on the upper surface of the first layer 5 (see the cross-sectional view shown in (c) of FIG. 10). Thereafter, an excess material 6a formed on the bottom side of the second recess 8 is removed by ashing (see the cross-sectional view shown in (e) of FIG. 10). The angle formed between the bottom surface and the side surface of the second recess 8 is a right angle or an obtuse angle slightly larger than the right angle (specifically, the angle corresponding to the draft angle generated when the second recess 8 is formed by imprinting technique).

Next, second conductive lines 17 forming a second conductor pattern 14 are formed. Specifically, an adhesive layer 17a (see FIGS. 7 and 9) is formed in each of the second recesses 8 by vapor deposition or sputtering. Thereafter, a conductive layer 17b (see FIGS. 7 and 9) made of a conductive metal such as copper is staked on the adhesive layer 17a by electroplating, for example. Further, a blackening layer 18 (see FIGS. 7 and 9) is formed on the upper surface side of the conductive layer 17b by blackening. Thus, the second conductive lines 17 are formed in the second layer 6 (see the cross-sectional view shown in (e) of FIG. 10). In this step, a via portion 22 is formed at a position where the excess material 6a of the second recess 8 is removed.

The production of the multilayer wiring substrate 1 ends up with the above process.

### [Advantageous Effects of Embodiments]

As described above, the multilayer wiring substrate 1 according to the embodiment of the present disclosure includes multiple first conductor patterns 10 and multiple second conductor patterns 14 arranged at different positions from each other in the thickness direction of the substrate 3. The first conductor patterns 10 are each made of multiple first conductive lines 13 which have been thinned. The second conductor patterns 14 are each made of multiple second conductive lines 17 which have been thinned. With such a configuration, the multilayer wiring substrate 1 can ensure transparency and light transmission of the substrate 3 in contrast to the configuration of prior art (e.g., a wiring substrate including solid conductive patterns and solid vias disclosed in Patent Document 1).

The intersection P at which the first conductive line 13 and the second conductive line 17 intersect with each other in the connection region 21 of the overlapping pattern 20 is formed such that the via portion 22 is electrically connected to the first conductive line 13. With such a configuration, the first conductor patterns 10 and the second conductor patterns 14 can be electrically connected to each other. In other words, in the multilayer wiring substrate 1, the first conductor patterns 10 and the second conductor patterns 14 arranged at different positions in the thickness direction of the substrate 3 can be electrically connected to each other by via portions 22.

Each of the via portions 22 in this embodiment has the same line width as the line width of each of the second conductive lines 17. Thus, the via portions 22 can be identified with each of the second conductive lines 17 in a plan view. In other words, the via portions 22 are not conspicuous in a plan view. As a result, the multilayer wiring substrate 1 does not impair transparency and light transmission of the substrate 3 in contrast to the configuration of prior art (a wiring substrate shown in Patent Document 1).

As described above, in the embodiment of the present disclosure, the multilayer wiring substrate 1 having a via structure can ensure transparency and light transmission of the substrate 3.

In the connection region 21 of this embodiment, two first conductive lines 13, 13 intersect with one second conductive line 17. The via portion 22 is electrically connected to the two first conductive lines 13, 13 at intersections P, P at which the two first conductive lines 13, 13 intersect with one second conductive line 17. Thus, for example, even when some abnormality occurs in the electrical connection state between the first conductive line 13 and the second conductive line 17 at one of the intersections P, P, the electrical connection state between the first conductor pattern 10 and the second conductor pattern 14 in the connection region 21 can be stable if the electrical connection state between the first conductive line 13 and the second conductive line 17 at the other intersection P is normal. In other words, the conduction reliability of the multilayer wiring substrate 1 can be enhanced.

For example, in the multilayer wiring substrate 1 formed by imprinting technique, the first conductive line 13 and the via portion 22 overlap with each other at the intersection P in the thickness direction of the substrate 3 in a cross-sectional view. Thus, the first conductive line 13 and the via portion 22 are electrically connected to each other. Therefore, in the connection region 21, the electrical connection state between the first conductor pattern 10 and the second conductor pattern 14 can be stable.

The via portion 22 is formed such that the length (dimension L shown in FIG. 6) along the extending direction of the second conductive line 17 is equal to or greater than the sum of the pitch interval (dimension A shown in FIG. 6) of the first conductive lines 13, 13 adjacent to each other in the extending direction and the line width (dimension W shown in FIG. 6) of one first conductive line 13. With such a configuration, the via portion 22 is easily disposed to be in contact with at least one first conductive line 13 located in the connection region 21. This makes it possible to electrically connect the via portion 22 to at least one first conductive line 13 located in the connection region 21 even if alignment between the first conductor pattern 10 and the second conductor pattern 14 in a plan view is slightly off in the process of producing a multilayer wiring substrate 1, for example. Therefore, the electrical connection state between the first conductor pattern 10 and the second conductor pattern 14 can be stable.

The connection region 21 according to this embodiment is smaller than the region of the overlapping pattern 20. This makes it possible to ensure that the number of intersections P at which the first conductive lines 13 and the second conductive lines 17 intersect with each other is unchanged even if alignment of the first conductor pattern 10 and the second conductor pattern 14 in a plan view is slightly off in the connection region 21. As a result, the electrical connection state between the first conductor pattern 10 and the second conductor pattern 14 can be stable.

The substrate 3 includes a film base material 4 having flexibility. This makes it possible to attach the multilayer wiring substrate 1 including a substrate 3 to external devices (not shown) having not only a flat mounting shape, but also various shapes of mounting surfaces, such as a curved mounting surface.

The upper surface of the first layer 5 is formed in a flat shape with the first conductive lines 13 embedded in the first recesses 7. This makes it possible to stack the second layer 6 on the upper surface of the first layer 5. Further, the upper surface of the second layer 6 is formed in a flat shape with the second conductive lines 17 embedded in the second recesses 8. This facilitates the arrangement of the mounted elements 2 on the multilayer wiring substrate 1. Further, when a functional layer (not shown) is stacked on the multilayer wiring substrate 1, the total thickness of the multilayer wiring substrate 1 and the functional layer tends to be constant. This facilitates stacking of other members such as the functional layer on the multilayer wiring substrate 1.

The first conductor pattern 10 and the second conductor pattern 14 are each in a mesh pattern, and the first conductive lines 13 and the second conductive lines 17 each have a line width of 15 µm or less. This configuration can ensure transparency and light transmission of the substrate 3.

The overlapping pattern 20 has the same aperture ratio as the aperture ratio of each first conductor pattern 10 and the aperture ratio of each second conductor pattern 14. Thus, in a plan view, a view of the overlapping pattern 20 is the same as a view of each first conductor pattern 10 and a view of each second conductor pattern 14. In other words, the overlapping pattern 20 is not conspicuous in contrast to each first conductor pattern 10 and each second conductor pattern 14 in a plan view. This enhances visibility of the multilayer wiring substrate 1.

The dummy pattern 30 has the same aperture ratio as the aperture ratio of each first conductor pattern 10 and the aperture ratio of each second conductor pattern 14. Thus, in a plan view, a view of the dummy pattern 30 is the same as a view of each first conductor pattern 10 and a view of each second conductor pattern 14. As a result, in a plan view, each first conductor pattern 10 and each second conductor pattern 14 are not conspicuous. Therefore, in a plan view or a bottom view, a view of the first conductor patterns 10 and a view of the second conductor pattern 14 located in the plane of the multilayer wiring substrate 1 are unified, and multiple lines forming each pattern are less likely to be visually recognized. This enhances visibility of the multilayer wiring substrate 1.

The second conductive lines 17 each include an adhesive layer 17a formed on at least the bottom surface of the second recess 8 and a blackening layer 18 stacked on the upper surface of the conductive layer 17b. The adhesive layer 17a and the blackening layer 18 make each second conductive line 17 less visible when the multilayer wiring substrate 1 is viewed from above or below. This enhances visibility of the multilayer wiring substrate 1.

### [First Variation of Embodiment]

In the configuration of the embodiment, each first conductor pattern 10 is in a mesh pattern in which multiple first conductive lines 13 are arranged in a mesh shape, but the configuration is not limited thereto. Each second conductor pattern 14 is also not limited to be in a mesh pattern in which multiple second conductive lines 17 are arranged in a mesh shape.

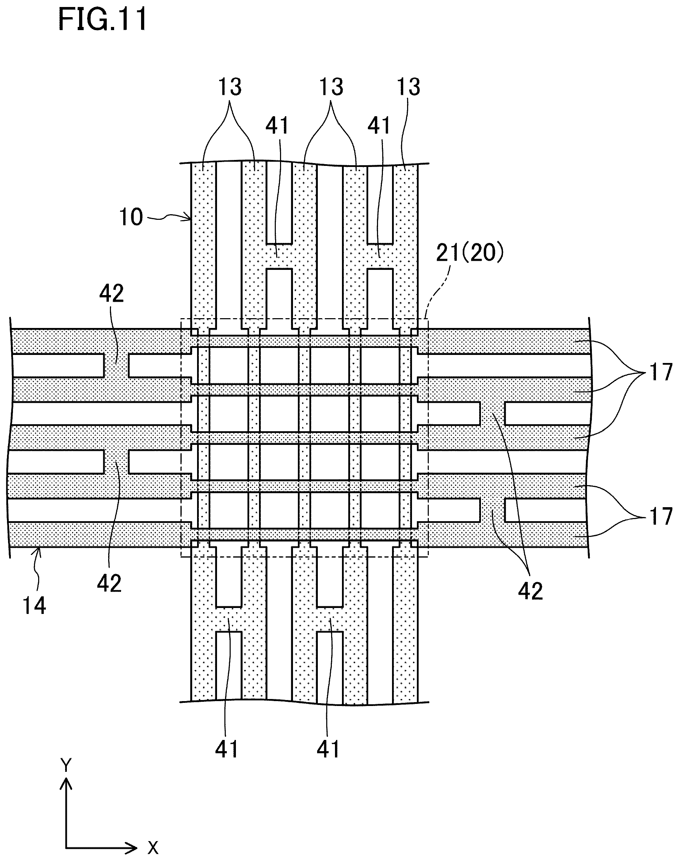

For example, as in the first variation shown in FIG. 11, the first conductor patterns 10 may be configured in a pattern (ladder-shaped pattern) in which multiple first conductive lines 13 are arranged in a ladder shape. Similarly, each second conductor pattern 14 may be configured to be in a pattern (ladder-shaped pattern) in which multiple second conductive lines 17 are arranged in a ladder shape.

In this variation, first conductive lines 13 and the second conductive lines 17 each have a line width of 15 µm or less. The first conductive lines 13 and the second conductive lines 17 have each been thinned. Thus, this variation can also ensure transparency and light transmission of the substrate 3 in the same manner as in the embodiment.

In the configuration of this embodiment, the connection region 21 is smaller than a region of an overlapping pattern 20, but the configuration is not limited thereto. For example, as in the first variation, the connection region 21 may have the same size as the size of the overlapping pattern 20. In other words, the connection region 21 of the first variation coincides with the overlapping pattern 20.

Multiple first bridge portions 41 are provided in the first conductor pattern 10 located in a region other than the connection region 21. The first bridge portions 41 each extend in a direction (X direction) orthogonal to the extending direction of each of the first conductive lines 13 and are each disposed between adjacent first conductive lines 13, 13. In this way, by providing multiple first bridge portions 41, conduction reliability of the first conductor pattern 10 can be enhanced.

Multiple second bridge portions 42 are provided in the second conductor pattern 14 located in a region other than the connection region 21. The second bridge portions 42 each extend in a direction (Y direction) orthogonal to the extending direction of each of the second conductive lines 17 and are each disposed between adjacent second conductive lines 17, 17.

On the other hand, the first bridge portions 41 and the second bridge portions 42 are not arranged in the connection region 21. Further, in the connection region 21, the first conductive lines 13 and the second conductive lines 17 have each been further thinned. Specifically, the first conductive lines 13 are each formed such that the line width of the portion located in the connection region 21 is approximately half the line width of the portion located in the region other than the connection region 21. Similarly, the second conductive lines 17 are each formed such that the line width of the portion located in the connection region 21 is approximately half the line width of the portion located in the region other than the connection region 21. With such a configuration, a desired aperture ratio can be easily obtained in the connection region 21 (overlapping pattern 20).

The aperture ratio of the overlapping pattern 20 (connection region 21) in the first variation is preferably made such that the difference between the aperture ratio of the overlapping pattern 20 and the aperture ratio of the first conductor pattern 10 (or the aperture ratio of the second conductor pattern 14) in the region other than a connection region 21 is 30% or less as in the embodiment. The difference between the aperture ratios is more preferably 10% or less.

### [Second Variation of Embodiment]

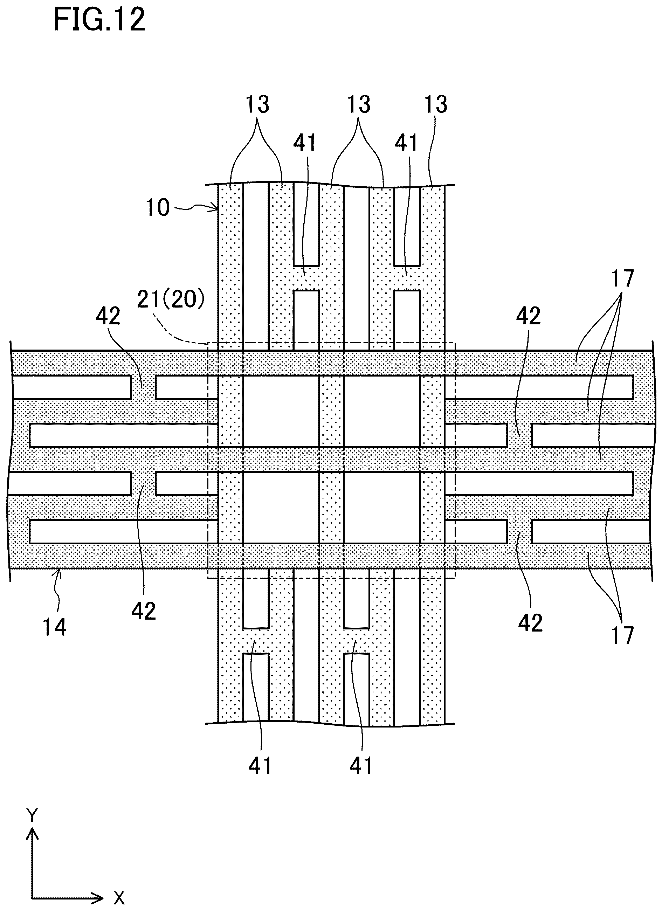

A second variation shown in FIG. 12 is a further variation of the first variation. The second variation is configured such that the number of first conductive lines 13 and the number of second conductive lines 17 in the connection region 21 are smaller than the number of first conductive lines 13 and the number of second conductive lines 17 in the region other than the connection region 21.

Specifically, as illustrated in FIG. 12, the number of first conductive lines 13 located in the region other than the connection region 21 is five, whereas the number of the first conductive lines 13 located in the connection region 21 is three. Similarly, the number of second conductive lines 17 located in the region other than the connection region 21 is five, whereas the number of the second conductive lines 17 located in the connection region 21 is three. This makes it possible to make the aperture ratio of the overlapping pattern 20 larger than the aperture ratio of the first conductor pattern 10 and/or the aperture ratio of the second conductor pattern 14 located in the region other than the connection region 21.

In the second variation, the line width of each of the first conductive lines 13 located in the connection region 21 is the same as the line width of each of the first conductive lines 13 located in the region other than the connection region 21. Similarly, the line width of each of the second conductive lines 17 located in the connection region 21 is the same as the line width of each of the second conductive lines 17 located in the region other than the connection region 21.

### [Third Variation of Embodiment]

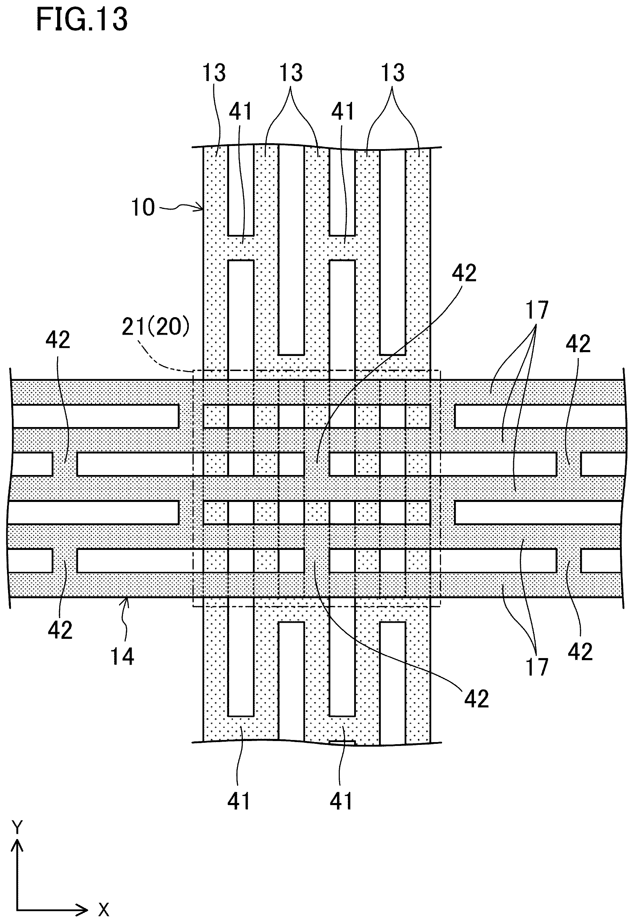

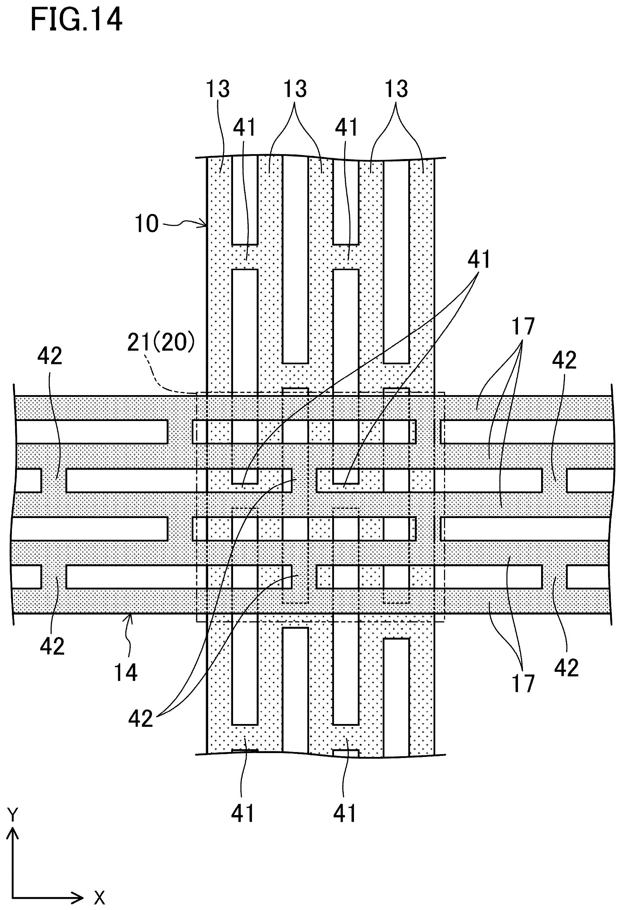

A third variation shown in FIGS. 13 and 14 is a further variation of the first variation. In the third variation, unlike the first variation, multiple first bridge portions 41 and multiple second bridge portions 42 are provided in the connection region 21 (overlapping pattern 20).

In the third variation, unlike the first variation, the line width of each of the first conductive lines 13 located in the connection region 21 is the same as the line width of each of the first conductive lines 13 located in the region other than the connection region 21. The line width of each of the second conductive lines 17 located in the connection region 21 is also the same as the line width of each of the second conductive lines 17 located in the region other than the connection region 21.

In other words, the configuration of the third variation may be employed as long as the difference between the aperture ratio of the overlapping pattern 20 (connection region 21) and the aperture ratio of the first conductor pattern 10 (or the aperture ratio of the second conductor pattern 14) located in the region other than the overlapping pattern 20 is 30% or less.

In FIG. 13, in a plan view, all of the first bridge portions 41 located in the connection region 21 entirely overlap with the second conductive lines 17, and all of the second bridge portions 42 located in the connection region 21 entirely overlap with the first conductive lines 13.

In contrast, in FIG. 14, in a plan view, the first bridge portions 41 located in the connection region 21 partially overlap with the second conductive lines 17, and the second bridge portions 42 located in the connection region 21 partially overlap with the first conductive lines 13. Even in the state shown in FIG. 14, if the difference between the aperture ratio of the overlapping pattern 20 (connection region 21) and the aperture ratio of the first conductor pattern 10 (or the aperture ratio of the second conductor pattern 14) located in the region other than the overlapping pattern 20 is 30% or less, no particular problem occurs in ensuring transparency and light transmission of the substrate 3.

### [Fourth Variation of Embodiment]

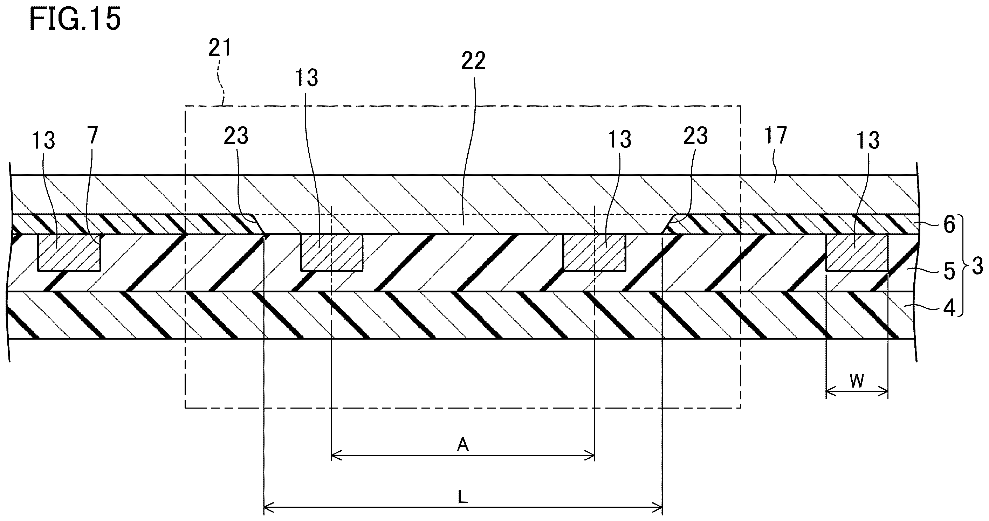

In the configuration of the embodiment, the via portion 22 is formed such that the angle formed between the side surface of the via portion 22 and the lower surface of the second conductive line 17 is substantially a right angle in a cross-sectional view, but the configuration is not limited thereto. For example, as in the fourth variation shown in FIG. 15, the via portion 22 may be formed such that the angle formed between the side surface of the via portion 22 and the lower surface of the second conductive line 17 is an obtuse angle in a cross-sectional view.

Specifically, as illustrated in FIG. 15, the via portion 22 of the fourth variation has an inclined portion 23. The inclined portion 23 is formed to be tapered from the lower portion of the second conductive line 17 toward the lower side of the substrate 3 in a cross-sectional view. It is preferable that the angle formed between the inclined portion 23 and the lower surface of the second conductive line 17 is an angle (obtuse angle) greater than the draft angle generated when the second recess 8 is formed by imprinting technique. A joint portion between the lower portion of the second conductive line 17 and the inclined portion 23 is formed in a curved shape (gentle R shape) in a cross-sectional view. Thus, in contrast to the embodiment, in the fourth variation, current easily flows from the second conductive line 17 toward the via portion 22. As a result, the electrical conduction state between the first conductive line 13 and the second conductive line 17 can be enhanced.

In this variation, the angle formed between the bottom surface and the side surface of the first recess 7 is an obtuse angle (the angle corresponding to the draft angle) slightly larger than the right angle, as in the embodiment. The angle formed between the bottom surface and the side surface of the second recess 8 is also an obtuse angle (the angle corresponding to the draft angle) slightly larger than the right angle.

### [Fifth Variation of Embodiment]

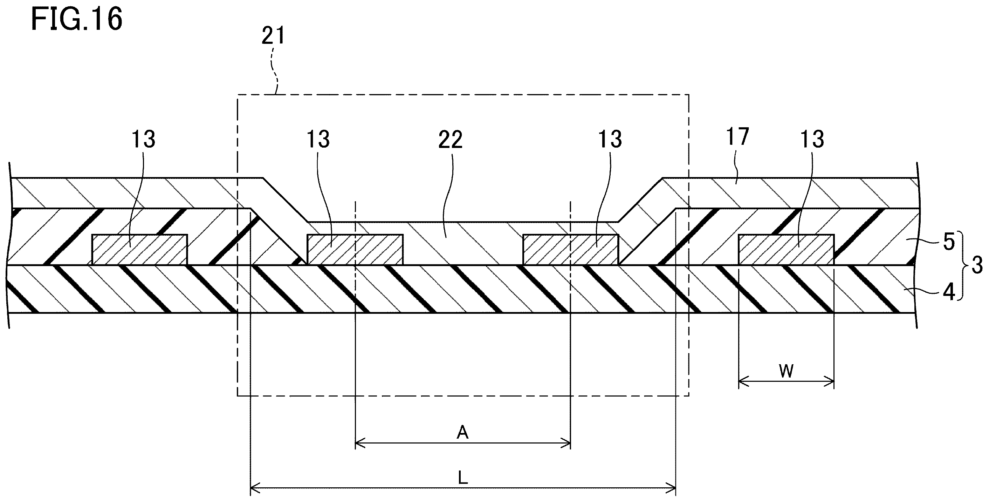

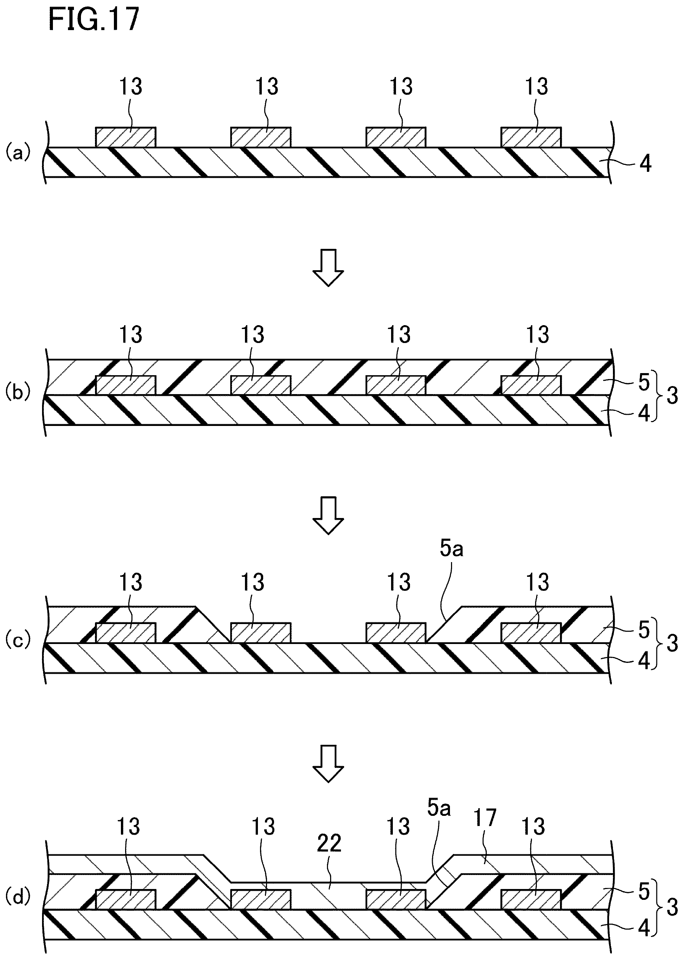

The embodiment shows the multilayer wiring substrate 1 formed by imprinting technique, but the multilayer wiring substrate 1 may be formed by technique other than imprinting technique. For example, as in a fifth variation shown in FIGS. 16 and 17, the multilayer wiring substrate 1 may be formed by etching technique.

A method for producing a multilayer wiring substrate 1 by etching technique will be described below with reference to FIG. 17.

First, multiple first conductive lines 13 forming a first conductor pattern 10 are formed on the upper surface of a film base material 4 by etching (photolithography) (see the cross-sectional view shown in (a) of FIG. 17).

Next, a first layer 5 is formed on the upper surface of the film base material 4. Specifically, a resin material having insulation properties and light transmission (the thermosetting resin material or the ultraviolet curable resin material) is applied to the upper surface of the film base material 4. Thus, the first layer 5 is stacked on the upper surface of the film base material 4 (see the cross-sectional view shown in (b) of FIG. 17).

Next, a cutout 5a for forming a via portion 22 is formed in the first layer 5 by ashing (see the cross-sectional view shown in (c) of FIG. 17). Thereafter, multiple second conductive lines 17 forming second conductor patterns 14 are formed on the upper surface of the first layer 5 by etching (photolithography) (see the cross-sectional view shown in (d) of FIG. 17). At the same time as forming the second conductive lines 17, a via portion 22 is formed at a position corresponding to the cutout 5a.

The production of the multilayer wiring substrate 1 of the fifth variation ends up with the above process.

As illustrated in FIG. 16, in the multilayer wiring substrate 1 formed by etching technique, the via portion 22 covers the first conductive lines 13 at the position corresponding to the intersection P in a cross-sectional view. Thus, as in the embodiment, the via portion 22 and the first conductive lines 13 are electrically connected to each other. Thus, even in the fifth variation, the first conductor patterns 10 and the second conductor patterns 14 arranged at different positions in the thickness direction of the substrate 3 can be electrically connected to each other by via portions 22 shown in FIG. 16.

### [Sixth Variation of Embodiment]

In this configuration of the embodiment, one via portion 22 overlaps, in the thickness direction of the substrate 3, with two first conductive lines 13,13 adjacent to each other in the extending direction of the second conductive line 17, but the configuration is not limited thereto. In other words, the via portion 22 may not be formed such that the length along the extending direction of the second conductive wire 17 is equal to or greater than the sum of the pitch interval of the first conductive lines 13, 13 adjacent to each other in the extending direction and the line width of one first conductive line 13.

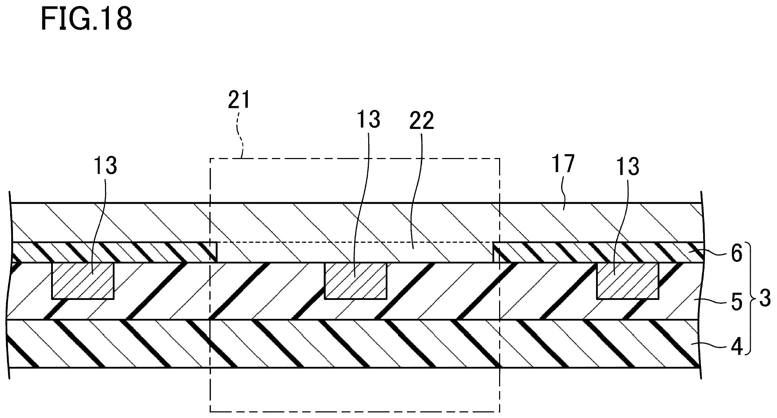

For example, as in the sixth variation shown in FIG. 18, one via portion 22 may be arranged to be in contact with one first conductive line 13. Thus, even in the sixth variation, the first conductor patterns 10 and the second conductor patterns 14 arranged at different positions in the thickness direction of the substrate 3 can be electrically connected to each other by via portions 22.

### [Other Embodiments]

In the configuration of the embodiment, the overlapping pattern 20 includes the connection region 21, but the configuration is not limited thereto. For example, the overlapping pattern 20 may include multiple connection regions 21. In other words, the overlapping pattern 20 may include at least one connection region 21.

In the configuration of the embodiment, one via portion 22 is provided in each of the second conductive lines 17 located in the connection region 21, but the configuration is not limited thereto. For example, multiple via portions 22 may be provided in each of the second conductive lines 17 located in the connection region 21. In other words, at least one via portion 22 may be provided in each of the second conductive lines 17 located in the connection region 21.

In the configuration of the embodiment, the line width of the via portion 22 is the same as the line width of the second conductive line 17, but the configuration is not limited thereto. In other words, the line width of the via portion 22 may be smaller than the line width of the second conductive line 17. Even with such a configuration, as in the embodiment, a view of the via portion 22 and a view of each of the second conductive lines 17 can be unified in a plan view, and the via portion 22 is not conspicuous. Thus, transparency and light transmission of the substrate 3 can be ensured.

In the configuration of the embodiment, the via portion 22 is electrically connected to two first conductive lines 13, 13 at intersections P, P at which the two first conductive lines 13, 13 intersect with one second conductive line 17, but the configuration is not limited thereto. In other words, the via portion 22 may be electrically connected to multiple first conductive lines 13 at two or more intersections P, P, ... where the first conductive lines 13 intersect with one second conductive line 17.

In the configuration of the embodiment, the aperture ratio of each first conductor pattern 10 is the same as the aperture ratio of each second conductor pattern 14, but the configuration is not limited thereto. In other words, the aperture ratio of each first conductor pattern 10 may be different from the aperture ratio of each second conductor pattern 14.

In the configuration of the embodiment, the overlapping pattern 20 has the same aperture ratio as the aperture ratio of each first conductor pattern 10 and the aperture ratio of each second conductor pattern 14, but the configuration is not limited thereto. For example, when the aperture ratio of each first conductor pattern 10 is different from the aperture ratio of each second conductor pattern 14, the overlapping pattern 20 may be formed to have the same aperture ratio as the aperture ratio of the first conductor pattern 10. Alternatively, the overlapping pattern 20 may be formed to have the same aperture ratio as the aperture ratio of the second conductor pattern 14.

In the configuration of the embodiment, the dummy patterns 30 are arranged in the first layer 5, but the configuration is not limited thereto. In other words, the dummy patterns 30 may be arranged in the second layer 6.

While the embodiments of the present disclosure have been described above, the present disclosure is not limited thereto and various modifications can be made within the scope of the present disclosure.

### INDUSTRIAL APPLICABILITY

The present disclosure is industrially applicable as a multilayer wiring substrate.

### DESCRIPTION OF REFERENCE CHARACTERS

1: Multilayer Wiring Substrate
2: Mounted Element
3: Sub strate
4: Film Base Material
5: First Layer
6: Second Layer
7: First Recess
8: Second Recess
10: First Conductor Pattern
11: First Body Portion
12: First Branch Portion
13: First Conductive Line
13a: Adhesive Layer
13b: Conductive Layer
14: Second Conductor Pattern
15: Second Body Portion
16: Second Branch Portion
17: Second Conductive Line
17a: Adhesive Layer
17b: Conductive Layer
18: Blackening Layer
20: Overlapping Pattern
21: Connection Region
22: Via Portion
23: Inclined Portion
30: Dummy Pattern
31: Dummy Conductive Line
41: First Bridge Portion
42: Second Bridge Portion
P: Intersection

## Claims

1. A multilayer wiring substrate comprising:
a substrate having transparency and light transmission; and
a first conductor pattern and a second conductor pattern arranged at different positions from each other in a thickness direction of the substrate,
the first conductor pattern being made of multiple first conductive lines that have been thinned,
the second conductor pattern being made of multiple second conductive lines that have been thinned,
the first conductor pattern and the second conductor pattern being provided with an overlapping pattern where the first conductor pattern and the second conductor pattern partially overlap with each other in the thickness direction of the substrate,
in the overlapping pattern, the multiple first conductive lines and the multiple second conductive lines intersecting with each other in a plan view,
the overlapping pattern including at least one connection region where the multiple first conductive lines and the multiple second conductive lines are electrically connected to each other,
the second conductive lines located in the at least one connection region each having at least one via portion,
at an intersection at which one of the multiple first conductive lines and one of the multiple second conductive lines intersect with each other in the at least one connection region, the at least one via portion being formed to be electrically connected to the one of the multiple first conductive lines,
the at least one via portion having a line width equal to or lower than a line width of the one of the multiple second conductive lines.

2. The multilayer wiring substrate of claim 1, wherein
in the at least one connection region, some of the multiple first conductive lines and some of the multiple second conductive lines are arranged,
in the at least one connection region, the some of the multiple first conductive lines intersect with one of the some of the multiple second conductive lines,
the at least one via portion is electrically connected to the some of the multiple first conductive lines at two or more intersections at which the some of the multiple first conductive lines intersect with the one of the some of the multiple second conductive lines.

3. The multilayer wiring substrate of claim 1, wherein
at the intersection, the at least one via portion overlaps with the one of the multiple first conductive lines in the thickness direction in a cross-sectional view.

4. The multilayer wiring substrate of claim 1, wherein
at the intersection, the at least one via portion covers the one of the multiple first conductive lines in a cross-sectional view.

5. The multilayer wiring substrate of claim 1, wherein
the at least one via portion is formed such that a length along the extending direction of the multiple second conductive lines is equal to or greater than a sum of a pitch interval between associated two or the multiple first conductive lines adjacent to each other in the extending direction and a line width of one of the multiple first conductive lines.

6. The multilayer wiring substrate of claim 1, wherein
the at least one connection region is smaller than a region of the overlapping pattern.

7. The multilayer wiring substrate of claim 1, wherein
the substrate includes a film base material having flexibility.

8. The multilayer wiring substrate of claim 7, wherein
the substrate includes:
a first layer for arranging the first conductor pattern, the first layer being stacked on an upper side of the film base material; and
a second layer for arranging the second conductor pattern, the second layer being stacked on an upper side of the first layer,
the first layer and the second layer are each made of a material having insulating properties,
the first layer is provided with multiple first recesses recessed downward from an upper surface of the first layer,
the second layer is provided with multiple second recesses recessed downward from an upper surface of the second layer,
the multiple first conductive lines are embedded in the respective first recesses, and the second conductive lines are embedded in the respective second recesses,
the upper surface of the first layer is formed in a flat shape with the multiple first conductive lines embedded in the respective first recesses, and
the upper surface of the second layer is formed in a flat shape with the second conductive lines embedded in the respective second recesses.

9. The multilayer wiring substrate of claim 1, wherein
the first conductor pattern and the second conductor pattern are each formed in a mesh pattern, and
the multiple first conductive lines and the second conductive lines are formed to each have a line width of 15 µm or less.

10. The multilayer wiring substrate of claim 1, wherein
the overlapping pattern has the same aperture ratio as an aperture ratio of the first conductor pattern and/or an aperture ratio of the second conductor pattern.

11. The multilayer wiring substrate of claim 1, further comprising:
a dummy pattern arranged in a region of the substrate where the first conductor pattern and the second conductor pattern are not located in a plan view, wherein
the dummy pattern has the same aperture ratio as an aperture ratio of the first conductor pattern and/or an aperture ratio of the second conductor pattern.

12. The multilayer wiring substrate of claim 8, wherein
the multiple second conductive lines each include:
an adhesive layer formed on at least a bottom surface of each of the second recesses; and
a conductive layer stacked on the adhesive layer and embedded in each of the second recesses.

13. The multilayer wiring substrate of claim 12, wherein
the second conductive lines each further include a blackening layer stacked on an upper surface of the conductive layer.

14. The multilayer wiring substrate of claim 1, wherein
the first conductor pattern and the second conductor pattern are each formed in a mesh pattern, and
the multiple first conductive lines and the second conductive lines are formed to each have a line width of 15 µm or less.

15. The multilayer wiring substrate of claim 1, wherein
the at least one via portion is integral with the one of the multiple second conductive lines in the at least one connection region and protrudes from a lower portion of the one of the multiple second conductive lines toward a lower side of the substrate,
the at least one via portion includes an inclined portion formed to be tapered from the lower portion of the one of the multiple second conductive line toward the lower side of the substrate in a cross-sectional view, and
a joint portion between the lower portion of the one of the second conductive lines and the inclined portion is formed in a curved shape in a cross-sectional view.
